# EUROPEAN PATENT SPECIFICATION

(11) **EP 1 740 029 B1**
(45) Date of publication and mention of the grant of the patent: **12.09.2012**
(21) Application number: 06012641.4
(22) Date of filing: 20.06.2006
(51) Int. Cl.: H05K 1/11, H05K 3/34

(54) **Circuit substrate**
Schaltungssubstrat
Substrat de circuit

(30) Priority: 30.06.2005 JP 2005191310
(43) Date of publication of application: 03.01.2007
(73) Proprietor: OMRON Automotive Electronics Co., Ltd., Komaki, Aichi 485-0802 (JP)
(72) Inventor: Higasa, Koichi, c/o Omron Corporation, Shimogyo-ku, Kyoto-shi, Kyoto 600-8530 (JP); Sumimoto, Yoshiyuki, c/o Omron Corporation, Shimogyo-ku, Kyoto-shi, Kyoto 600-8530 (JP); Yoshioka, Daisuke, c/o Omron Corporation, Shimogyo-ku, Kyoto-shi, Kyoto 600-8530 (JP)
(74) Representative: Kilian, Helmut

(56) References cited:
- DE-A1- 2 528 000
- US-A- 5 842 275
- US-A- 6 069 323
- US-A1- 2005 263 318
- US-B1- 6 414 246

## Description

### BACKGROUND OF THE INVENTION

### 1. Field of the Invention

The present invention relates to a circuit substrate to which electronic components are connected and, more particularly, to a circuit substrate having improved connectability between electrodes.

### 2. Description of Related Art

In general, an electronic component is mounted on a surface of a circuit substrate by soldering it to an electrode formed on the same.

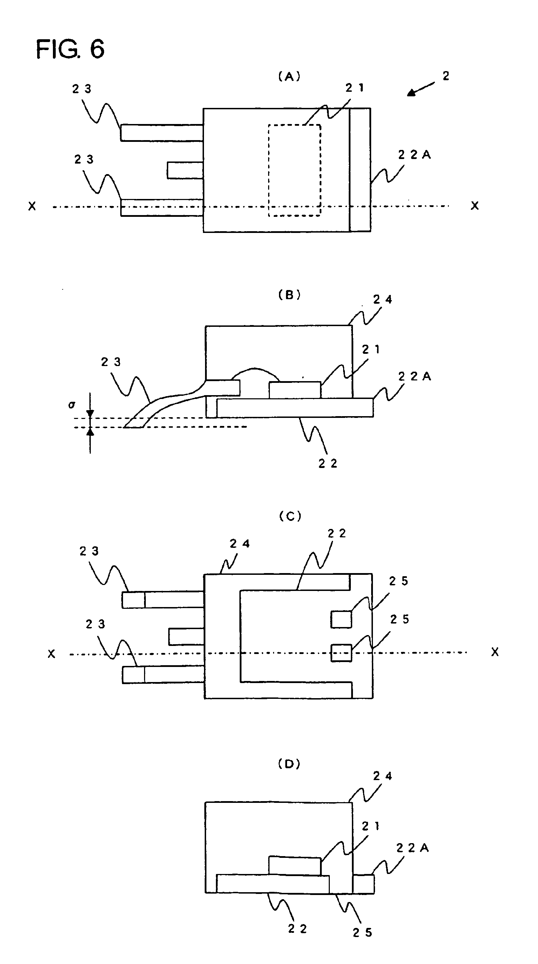

Figs. 6A to 6D show a MOSFET which is an example of an electronic component. The MOSFET is a power MOSFET which is mounted on a circuit substrate and through which a high current (e.g., 100 A) is passed. Heat is released through the circuit substrate on which the MOSFET is mounted. Fig. 6A is a top plan view of the MOSFET. Fig. 6B is a sectional view taken on the plane X-X shown in Fig. 6A. Fig. 6C is a bottom plan view of the same. Fig. 6D is a sectional view taken on the plane X-X shown in Fig. 6C. As shown in Figs. 6A, 6B, 6C and 6D, the MOSFET 2 is constituted by a semiconductor chip 21, a drain pad electrode 22 in the form of a flat plate bonded to a bottom surface of the semiconductor chip 21, lead terminals 23 electrically connected to the semiconductor chip 21 through metal wires such as aluminum wires, and a resin 24 molded to form the MOSFET 2 in a substantially rectangular shape.

The drain pad electrode protrudes outwardly from one side surface of the substantially rectangular resin 24. The protruding part will be referred to as a bulge 22A. The drain pad electrode 22 has a plurality of (two in the figures) anchor holes 25 at the end of the resin 24 where the bulge 22A is provided, the resin 24 penetrating through the anchor holes. The resin 24 penetrates through the anchor holes 25 of the drain pad electrode 22 to be exposed on an electrode surface of the drain pad electrode 22.

A plurality of the lead wires 23 are extended from a side of the resin 24, and bottom surfaces of the ends of the lead wires 23 are located lower than the electrode surface of the drain pad electrode 22 by a height σ. Either of the lead terminals 23 serves as a source electrode, and either of them serves as a gate electrode.

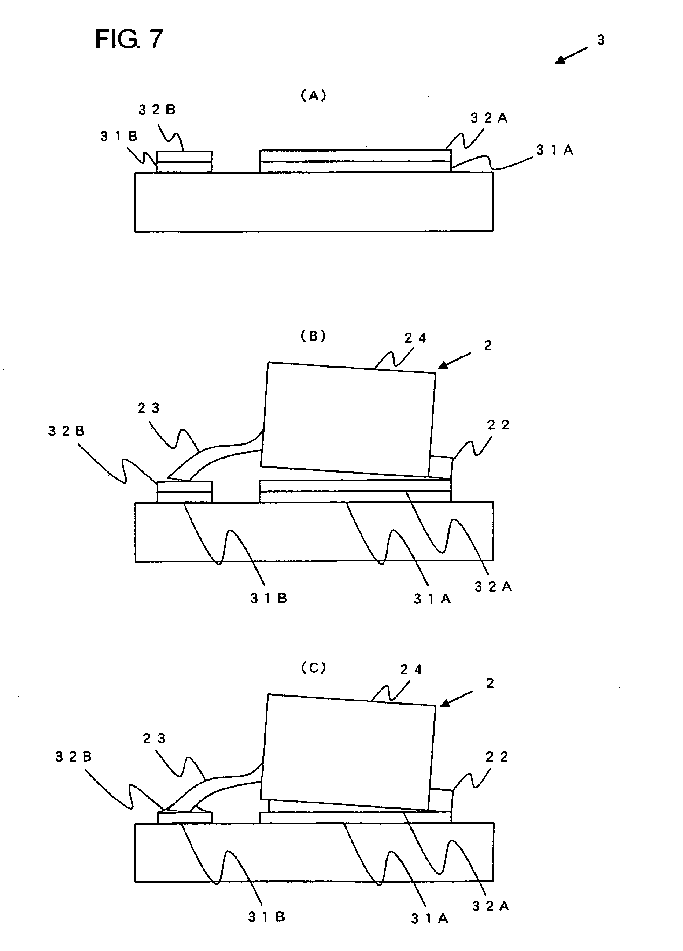

The drain pad electrode 22 and the lead terminals 23 are solder-mounted on the circuit substrate. Figs. 7A to 7D show an example of the MOSFET and the circuit substrate. Electrodes (lands) made of copper are formed on a top surface of a circuit substrate, and solder is printed on the electrodes at a circuit substrate packaging step. For example, as shown in Fig. 7A, there is formed a land 31A and a land 31B which are substantially rectangular when the circuit substrate 3 is viewed from above. The lands 31A and 31B are formed such that they will be in contact with the drain pad electrode 22 and end faces of the lead terminals 23, respectively. The land 31B is formed in a position where the two lead terminals 23 are in a face-to-face relationship. Solder paste 32A and solder paste 32B are printed on top surfaces of the land 31A and the land 31B, respectively. The MOSFET 2 is mounted on the solder paste 32A and the solder paste 32B.

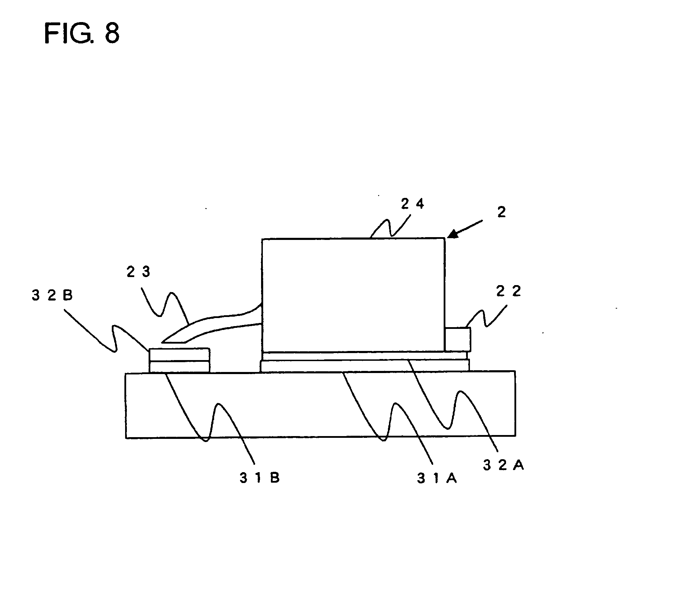

Fig. 7B shows the state in which the MOSFET 2 is placed on the solder paste 32A and the solder paste 32B. As shown in the same figure, since the ends of the lead terminals 23 are located lower than a bottom surface of the MOSFET 2 by σ, the MOSFET 2 is inclined from the lead wires 23 down to the bulge 22A of the drain pad electrode 22. It is idealistic that electrode surfaces at the ends of the lead terminals 23 are flush with the electrode surface of the drain pad electrode 22. However, they cannot be reliably made flush with each other in practice because of errors in the manufacture of the MOSFET 2. When the electrode surfaces at the ends of the lead terminals 23 are located higher than the electrode surface of the drain pad electrode 22 as shown in Fig. 8, the lead terminals 23 cannot be soldered because they are not in contact with the solder paste 32B. Therefore, the MOSFET 2 is manufactured such that the ends of the lead terminals 23 are located lower than the electrode surface of the drain pad electrode 22 taking errors in manufacture into consideration. When such a MOSFET 2 is placed on the circuit substrate, it is inclined from the lead terminals 23 down to the bulge 22A of the drain pad electrode 22. When the circuit substrate is heated in this state, as shown in Fig. 7C, the solder paste 32A and the solder paste 32B are melted, and the drain pad electrode 22 and the lead terminals 23 are soldered to the land 31A and the land 31B, respectively. The MOSFET is thus mounted inclined from the lead terminals 23 down to the bulge 22A of the drain pad electrode 22.

An electronic component is solder-mounted on a circuit substrate as described above, and solder-mounting has resulted in the following problems.

A gas of flux for preventing oxidation applied to a copper surface, air (bubbles) entrapped in solder when the solder is melted, and a gas of flux included in the solder paste may intervene between a land and a pad electrode. When the solder is set in this state, a great space (void) may be formed between the land and resin exposed at an anchor hole of the pad electrode. Such a void may result in a reduction in the strength of connection between the land and the pad electrode and a reduction in thermal conductivity.

Under the circumstance, in an intention to prevent the generation of bubbles, circuit substrates provided with a through hole in a ground pattern to release air have been proposed (see JP-A-11-31876 for example). Substrates to be packaged with chips have been also proposed, on which a groove is provided in a bonding tape applying position to release bubbles generated at a bonding tape for temporarily holding a chip (molded body) (see JP-A-5-75230 for example).

In the MOSFET 2 shown in Figs. 6A to 6D, the resin 24 is exposed on the electrode surface of the drain pad electrode 22 at the anchor holes. Bubbles have tended to concentrate at such parts of the resin 24 because those parts do not get wet with the solder. Since the MOSFET 2 is inclined from the lead terminals 23 down to the bulge 22A of the drain pad electrode 22, the gap between the end of the drain pad electrode 22 and the land 31A is small, and solder aggregates and sets earlier in this region. In this case, the land 31A and the end of the drain pad electrode 22 are covered by the solder that has thus aggregated, and a problem has arisen in that there is no place to release bubbles concentrated in the region of the resin 24.

Further, from DE 2528001 A1, a circuit substrate on which a transistor is solder-mounted via its cooling surface, is known.

### SUMMARY OF THE INVENTION

It is an object of the present invention to provide a circuit substrate on which bubbles generated in solder can be eliminated. The object is achieved by a circuit substrate according to claim 1.

An aspect of the invention is directed to a circuit substrate on which an electronic component encapsulated with a resin in a substantially rectangular shape is solder-mounted, the electronic component includes a planar pad electrode formed on a bottom surface of the encapsulant and having an anchor hole located on a bottom surface of an end of the encapsulant through which the resin penetrates and a lead electrode extended from a side surface of another end of the encapsulant, an end of the electrode being located below an electrode surface of the pad electrode, wherein the circuit substrate is formed with a portion having no wetting property for connecting a part of a land on which the pad electrode is mounted and which faces the anchor hole and a part on which the pad electrode is not mounted.

According to the aspect of the invention, a portion having no wetting property is formed at an end of a land on a circuit substrate. On a pad electrode surface of an electronic component (e.g., a MOSFET), an anchor hole is formed at an end of an insulating body molded to form the MOSFET in a rectangular shape, and the insulating body penetrates through the anchor hole to be exposed below the pad electrode surface. When the MOSFET is soldered, the portion having no wetting property faces the insulating body exposed on the pad electrode surface. When solder between a land on the circuit substrate and the pad electrode of the MOSFET is melted, the MOSFET is placed on the portion having no wetting property, and the portion having no wetting property comes into contact with the insulating body protruding downward from the pad electrode surface. Therefore, a gap is formed between the pad electrode of the MOSFET and the land on the circuit substrate, and bubbles concentrated in the region of the insulating body protruding downward from the pad electrode escape from the gap between the land and the pad electrode through the portion having no wetting property.

Another aspect of the invention is characterized in that the portion having no wetting property is formed from a solder resist.

According to the aspect of the invention, the portion having no wetting property is formed from a solder resist. At a step of manufacturing the circuit substrate, a solder resist may be applied such that the solder resist is applied at an end of a land.

According to the invention, bubbles generated in solder between a pad electrode surface and a land can be eliminated.

### BRIEF DESCRIPTION OF THE DRAWINGS

Figs. 1A and 1B are views of a circuit substrate according to an embodiment of the invention.
Figs. 2A to 2C are views of an example of a circuit substrate and a MOSFET according to the embodiment of the invention.
Figs. 3A and 3B are views of a circuit substrate according to another embodiment of the invention.
Figs. 4A and 4B are views of a circuit substrate according to another embodiment of the invention.
Figs. 5A to 5C are views of a circuit substrate.
Figs. 6A to 6D are views of a MOSFET.
Figs. 7A to 7C are views of a related-art circuit substrate.
Fig. 8 is a view of a state of connection failure.

### DESCRIPTION OF PREFERRED EMBODIMENTS

A circuit substrate according to an embodiment of the invention will now be described in detail.

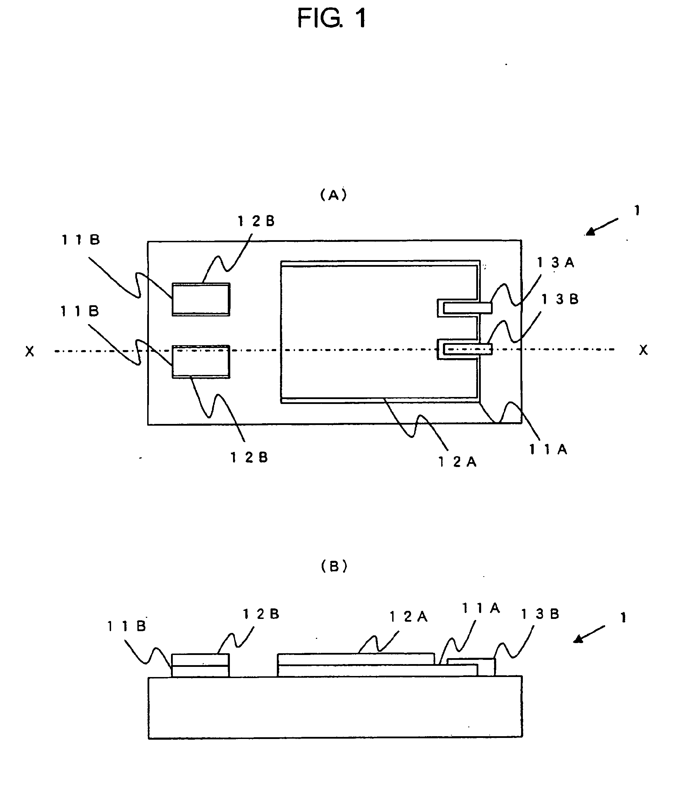

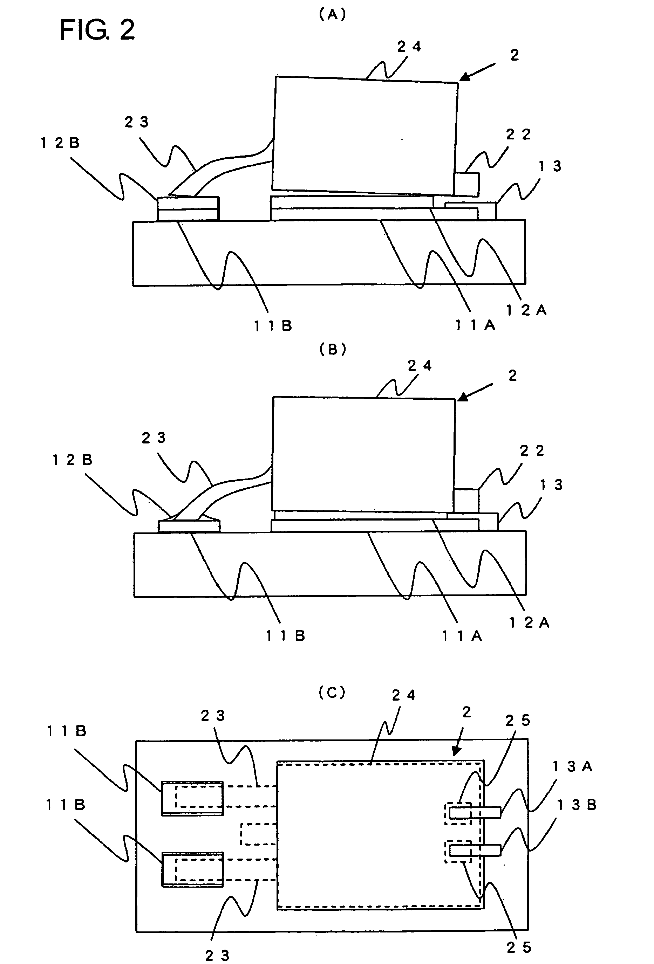

Figs. 1A and 1B are views of a region of a circuit substrate according to an embodiment of the invention in which a MOSFET 2 as shown in Figs. 2A to 2C is mounted. Fig. 1A is a top plan view of the circuit substrate. Fig. 1B is a sectional view taken on the plane X-X shown in Fig. 1A. As shown in Figs. 1A and 1B, the circuit substrate 1 has a land 11A, lands 11B, a resist 13A, and a resist 13B patterned thereon, and solder paste 12A and solder paste 12B are printed on the land 11A and the lands 11B, respectively.

The land 11A is formed on the circuit substrate with a small thickness in a rectangular shape, and it is patterned such that a top surface thereof overlaps a bottom surface of a drain pad electrode 22 as shown in Figs. 6A to 6D. The lands 11B are formed in a plurality of locations (two locations in the same figure) on the circuit substrate substantially in a rectangular shape, and they are patterned in positions apart from a side of the land 11A by an amount equivalent to the length of lead terminals 23 such that they overlap end faces of the lead wires 23 (a source electrode and a gate electrode) as shown in Figs. 6A to 6C. The term "patterning" means the act of intentionally forming an electrode or the like in a certain shape in a certain position.

The resist 13A and the resist 13B are solder resists (hereinafter simply referred to as resists) formed at the end of the land 11A opposite to the lands 11B such that they extend from a top surface of the land 11A and out of the land 11A. The resist 13A and the resist 13B are formed in a rectangular shape in a top plan view of the circuit substrate and with an L-shaped section such that they are in contact with the exterior of the land 11A. The resist 13A and the resist 13B are formed in positions apart from each other by a width that is the same as the width between two anchor holes 25 on the drain pad electrode 22 of the MOSFET 2 shown in Figs. 6A to 6D.

Solder paste 12A and solder paste 12B are thinly printed so as to cover top surfaces of the land 11A and the lands 11B, respectively.

The circuit substrate 1 is a so-called printed substrate and, in the present embodiment of the invention, it is obtained by forming an insulation plate (e.g., an epoxy resin plate) on a metal plate (e.g., an aluminum plate) having high heat radiating properties and forming an electrode (e.g., copper) on a top surface of the same. The materials in this example are not limiting of the invention. For example, a glass fiber plate may be used instead of an aluminum plate. Steps for manufacturing the circuit substrate 1 will now be described.

First, a photosensitive material (positive photosensitive resist) is formed on the electrode which is formed on an entire surface of the circuit substrate. The photosensitive material is exposed to ultraviolet light to pattern the same, and developing is performed to leave the photosensitive material only on wiring patterns and to expose the copper in other regions. Thereafter, only the exposed copper is dissolved by an etchant. After the copper is dissolved, any residue of the photosensitive material is removed by a photosensitive material removing liquid. Finally, flux is applied onto the copper to prevent oxidation.

When the lands are thus patterned to form the land 11A and lands 11B as described above. Further, a resist is applied to the circuit substrate 1 excluding a patterned part on which an electronic component is mounted. In the case of the circuit substrate 1 in the present embodiment of the invention, the resist is applied in two locations extending from a top surface of an end of the land 11A and out of the land 11A as shown in Fig. 1A.

Although Fig. 1A shows the electrode surface of the MOSFET as having a surface area similar to the surface area of the land, the land may be greater or smaller in surface area than the electrode surface of the MOSFET.

Solder paste 12A and solder paste 12B are printed on the land 11A and the land 11B formed as described above. Referring to Figs. 1A and 1B, the solder paste 12A is printed from one end of the lad 11A up to the region where the resist 13A and the resist 13B are formed. The solder paste 12B is printed throughout top surfaces of the lands 11B.

The MOSFET 2 as shown in Figs. 6A to 6D is solder-mounted on the circuit substrate 1. Figs. 2A to 2C show an example of the soldering between the circuit substrate 1 and the MOSFET 2. Fig. 2A shows a state in which the MOSFET 2 is placed on the solder paste 12A and the solder paste 12B. Since ends of lead terminals 23 protrude downward from the electrode surface of the drain pad electrode 22 by a length σ as shown in the same figure, the device inclines from the lead terminals 23 down to the drain pad electrode 22. The circuit substrate 1 and the MOSFET 2 are passed through a reflow oven to heat them. As a result of the heating, the solder paste 12A and the solder paste 12B are melted as shown in Fig. 2B.

When the solder paste 12A and the solder paste 12B are melted, the MOSFET 2 goes down, and a part of the electrode surface of the drain pad electrode 22 comes into contact with the resist 13A and the resist 13B, as shown in Fig. 2B. The resist 13A and the resist 13B are neither melted by the heating in a reflow oven nor wetted by the solder paste. Therefore, a gap is formed between the land 11A and the drain pad electrode 22 of the circuit substrate 1 especially at the end where the resist 13A and the resist 13B are formed as shown in Fig. 2B.

Heat radiating property is important for a power MOSFET because it is heated to a high temperature during operation by a high current passed through the same. On the related-art circuit substrate, as shown in Figs. 7A to 7C, solder aggregates in the narrow region between the drain pad electrode 22 and the land, and the end of the drain pad electrode 22 is covered by the solder which has thus aggregated. A problem has therefore arisen in that bubbles concentrated at the part of the resin 24 exposed on the bottom surface of the drain pad electrode 22 can escape to nowhere. When the solder sets with bubbles generated therein, since there is no solder in such parts, thermal conductivity between the drain pad electrode 22 and the land is reduced, which consequently degrades the heat radiating property of the MOSFET 2. The strength of mechanical connection is also reduced.

In the case of the circuit substrate 1 of the embodiment of the invention, since the electrode surface of the drain pad electrode 22 is in contact with the resist 13A and the resist 13B, there is a gap between the drain pad electrode 22 and the land 11A, and the resist does not wet the resist 13A and the resist 13B when melted. Thus, bubbles generated in the solder escape to the end of the land 11A through the gap.

Fig. 2C is a top plan view of the circuit substrate 1 with the MOSFET 2 placed thereon. As shown in Fig. 2C, the resist is patterned such that the two parts of the resin 24 penetrating through the electrode surface of the drain pad electrode 22 come into contact with the resist 13A and the resist 13B, respectively. Thus, bubbles which are likely to concentrate at the resin 24 exposed at the anchor holes 25 will escape from the gap created by the resist 13A and the resist 13B.

As thus described, on the circuit substrate according to the embodiment of the invention, a resist is formed on an end of a land, and an electrode of an electronic component comes into contact with the resist to create a gap between the land and the electrode. Since bubbles generated in solder therefore escapes to the end of the land through the gap, mechanical strength is improved, and the heat radiating property of a MOSFET can be improved.

The resist 13A and the resist 13B described above can be formed only by making a change in the mask pattern used for applying the resist, and there is no increase in the number of processing steps. It is therefore possible to eliminate bubbles in solder reliably in spite of the simple configuration.

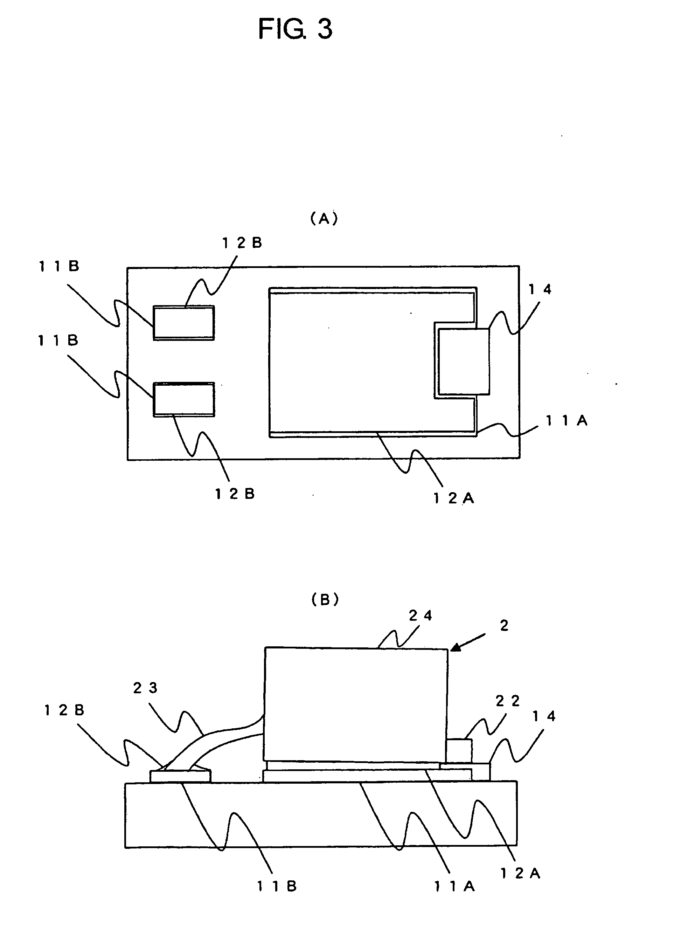

A circuit substrate according to the invention may be provided in a configuration as described below. Figs. 3A and 3B show a circuit substrate according to another embodiment of the invention. The circuit substrate shown in Fig. 3A includes a resist 14 instead of the resist 13A and the resist 13B on the circuit substrate 1 shown in Fig. 1A. Constituent parts similar to those of the circuit substrate 1 shown in Fig. 1A are indicated by like reference numerals and are omitted in the description.

The resist 14 is formed at an end of a land 11A opposite to a land 11B similarly to the resist 13A and the resist 13B. The resist 14 is also applied and formed using a mask pattern. The resist 14 is formed in a rectangular shape in a top plan view thereof with an L-shaped section, and it is greater than the resist 13A and the resist 13B in surface area in the top plan view thereof.

In this example again, as shown in Fig. 3B, when a MOSFET 2 is placed on a top surface and solder paste is melted in a reflow oven, an electrode surface of a drain pad electrode 22 of the MOSFET 2 comes into contact with the resist 14. Therefore, just as seen on the circuit substrate 1 shown in Fig. 1A, the electrode surface of the drain pad electrode 22 thus comes into contact with the resist 14 to create a gap between the land 11A and the drain pad electrode 22, and the solder does not wet the resist 14 when it is melted. As a result, bubbles generated in the solder escape to the end of the land 11A through the gap.

As thus described, a resist formed on a land may have any shape.

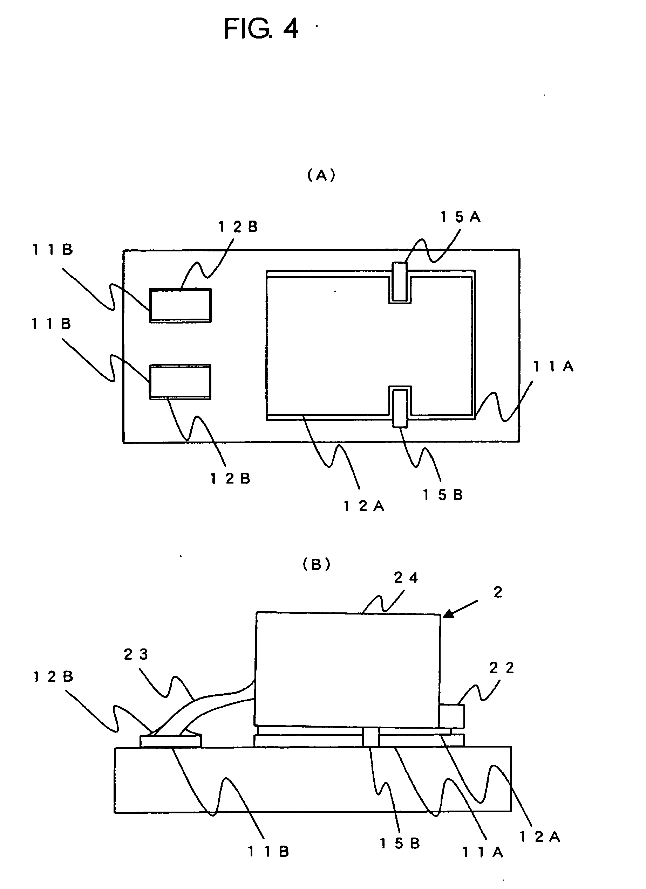

Referring to Fig. 4A, a resist 15A and a resist 15B are provided instead of the resist 13A and the resist 13B shown in Fig. 1A. In this example, constituent parts similar to those of the circuit substrate 1 shown in Fig. 1A are indicated by like reference numerals and will be omitted in the description.

Unlike the resist 13A and the resist 13B shown in Fig. 1A, the resist 15A and the resist 15B are formed on edges of the land 11A in intermediate positions between the side of lands 11B and the opposite side. The resist 15A and the resist 15B are also applied and formed using a mask pattern. The resist 15A and the resist 15B are formed so as to extend from the top of the land 11A and across the edges of the same, the resists having a substantially rectangular shape when viewed from above and an L-shaped section.

In this example again, as shown in Fig. 4B, when a MOSFET 2 is placed on a top surface and solder paste is melted in a reflow oven, an electrode surface of a drain pad electrode 22 of the MOSFET 2 comes into contact with the resist 15A and the resist 15B. Therefore, just as seen on the circuit substrate 1 shown in Fig. 1A, the electrode surface of the drain pad electrode 22 thus comes into contact with the resist 15A and the resist 15B to create a gap between the land 11A and the drain pad electrode 22, and bubbles generated in the solder escape between the electrodes through the gap.

As thus described, the position of the resist formed on the land is not limited to the end opposite to the lands 11B.

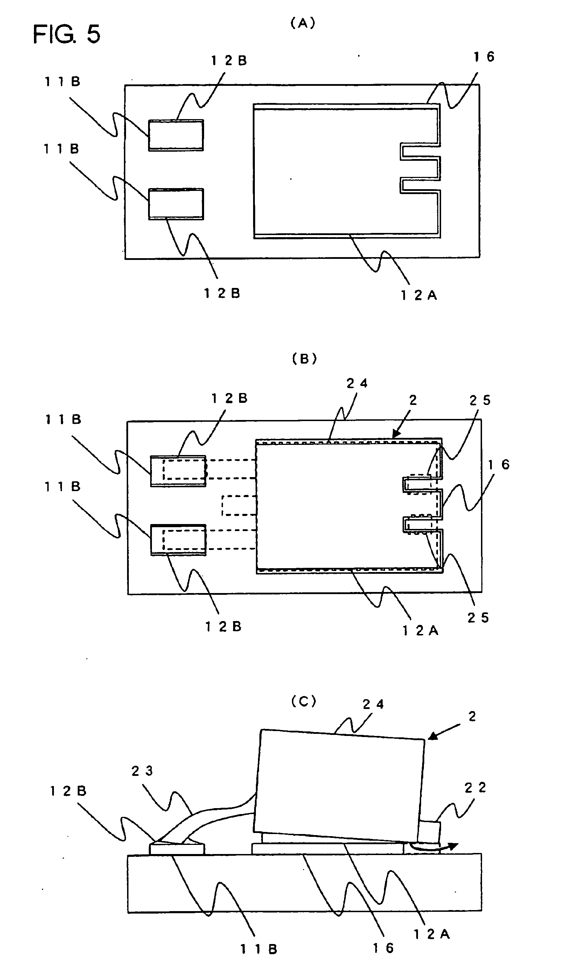

Figs. 5A to 5C show a circuit substrate. In this example again, constituent parts similar to those in the circuit substrate 1 shown in Fig. 1A are indicated by like reference numerals and omitted in the description.

The circuit board shown in Fig. 5A has a land 16 instead of the land 11A on the circuit substrate 1 shown in Fig. 1A, and it has neither resist 13A nor resist 13B. As shown in Fig. 5A, the land 16 has substantially rectangular cut-outs in two locations at the end opposite to lands 11B, and two parts of a resin 24 penetrating through an electrode surface of a drain pad electrode 22 cover the cut-outs from above as shown in Fig. 5B.

Since the lads on the circuit substrate are patterned using etching as described above, it is required only to form the exposure pattern in the shape of the land 16 shown in Fig. 5A, and there is no increase in the number of processing steps.

When the land 16 is configured such that the two parts of the resin 24 penetrating through the electrode surface of the drain pad electrode 22 overlap the cut-outs of the land as thus described, an air path is formed under the resin 24 as shown in Fig. 5C. Therefore, bubbles which are likely to concentrate in the resin 24 escape to an end of the land through the air path. As thus described, a land may be provided with cut-outs instead of forming a resist on the land.

An electronic component mounted on a circuit substrate according to the invention is not limited to a MOSFET as shown in Figs. 6A to 6D. The effect of eliminating bubbles can be expected in mounting other general electronic components. Connection of an electronic component is not limited to the use of solder and may be carried out using a conductive adhesive or the like. Bubbles generated in a conductive adhesive can be also eliminated.

## Claims

1. A circuit substrate (1) on which an electronic component (2) encapsulated with a resin (24) in a substantially rectangular shape is solder-mounted,
said electronic component (2) including:
a planar pad electrode formed on a bottom surface of said resin (24) and having an anchor hole (25) located on a bottom surface of an end of the resin (24) through which said resin penetrates; and
a lead electrode (23) extended from a side surface of another end of said resin (24), an end of the electrode (23) being located below an electrode surface of said pad electrode;
wherein said circuit substrate (1) is formed with a portion (13) having no wetting property which extends from a top surface of a part of a land on which said pad electrode (22) is mounted and out of said land, said portion (13)facing said anchor hole (25) and coming into contact with said resin penetrating through said anchor hole, whereby a gap is formed between said pad electrode and said land.

2. A circuit substrate according to Claim 1, wherein said portion having no wetting property is formed from a solder resist.

## Patentansprüche

1. Schaltungssubstrat (1), auf welchem ein elektronisches Baumelement (2) durch Löten befestigt ist, und welches in im Wesentlichen rechteckförmiger Form mit Harz (24) vergossen ist,
wobei das elektronische Bauelement (2) umfasst:
eine planare Kontaktelektrode, die auf einer Bodenfläche des Harzes (24) ausgebildet ist, und ein Ankerloch (25) aufweist, welches auf einer Bodenfläche eines Endes des Harzes (24) angeordnet ist und durch welches das Harz durchdringt; und
eine Anschlusselektrode (23) die sich von einer Seitenfläche eines anderen Endes des Harzes (24) erstreckt, und ein Ende der Elektrode (23) unterhalb einer Elektrodenfläche der Kontaktelektrode angeordnet ist;
wobei das Schaltungssubstrat (1) mit einem Teilbereich (13) gebildet ist, der keine Benetzungseigenschaft aufweist, und der sich von einer oberen Oberfläche eines Teils einer Anschlussfläche, auf der die Kontaktelektrode (22) befestigt ist, und aus der Anschlussfläche heraus erstreckt, der Teilbereich (13) dem Ankerloch (25) zugewandt ist und in Kontakt mit dem durch das Ankerloch durchdringenden Harz kommt, wobei zwischen der Kontaktelektrode und der Anschlussfläche ein Zwischenraum ausgebildet ist.

2. Schaltungssubstrat gemäß Anspruch 1, wobei der Teilbereich, der keine Benetzungseigenschaft aufweist, durch einen Lötstopplack gebildet ist.

## Revendications

1. Substrat de circuit (1) sur lequel est fixé par soudure un composant électronique (2) encapsulé avec une résine (24) selon une forme sensiblement rectangulaire,
ledit composant électronique (2) comprenant :
une électrode formant pastille planaire formée sur une surface inférieure de ladite résine (24) et présentant un trou d'ancrage (25) situé sur la surface inférieure d'une extrémité de la résine (24) à travers lequel pénètre ladite résine ; et
une électrode de plomb (23) s'étendant depuis une surface latérale d'une autre extrémité de ladite résine (24), une extrémité de l'électrode (23) étant située sous une surface d'électrode de ladite électrode formant pastille ;
dans lequel ledit substrat de circuit (1) est formé d'une portion (13) ne présentant pas de propriété mouillante qui s'étend depuis une surface supérieure d'une partie d'un méplat sur lequel est fixé ladite électrode formant pastille (22) et en dehors dudit méplat, ladite portion (13) étant orientée vers ledit trou d'ancrage (25) et venant en contact avec ladite résine pénétrant à travers ledit trou d'ancrage, moyennant quoi un jeu est formé entre ladite électrode formant pastille et ledit méplat.

2. Substrat de circuit selon la revendication 1, dans lequel ladite portion ne présentant pas de propriété mouillante est formée à partir d'une réserve de soudure.
